# EUROPEAN PATENT SPECIFICATION

(11) **EP 1 153 665 B1**
(45) Date of publication and mention of the grant of the patent: **31.10.2007**
(21) Application number: 00307888.8
(22) Date of filing: 12.09.2000
(51) Int. Cl.: B05B 13/00, B05B 13/02, H05K 3/00, B08B 3/02

(54) **Device for surface treatment of sheet material**
Vorrichtung zur Oberflächenbehandlung von Blattmaterial
Dispositif de traitement de surface de matériau en feuilles

(30) Priority: 11.05.2000 JP 2000138361
(43) Date of publication of application: 14.11.2001
(73) Proprietor: Tokyo Kakoki Co., Ltd., Edogawa-ku, Tokyo (JP)
(72) Inventor: Niiyama, Kisaburo, Tokyo Kakori Co., Ltd., Tokyo (JP); Midorikawa, Masahiro, Tokyo Kakori Co., Ltd., Tokyo (JP); Sugawara, Kiyosi, Tokyo Kakori Co., Ltd., Tokyo (JP)
(74) Representative: Haley, Stephen

(56) References cited:
- EP-A- 0 967 845
- "SPRAY NOZZLE CONFIGURATION FOR MAXIMIZING DEVELOP/ETCH RATE AND UNIFORMITY" IBM TECHNICAL DISCLOSURE BULLETIN, IBM CORP. NEW YORK, US, vol. 38, no. 4, 1 April 1995 (1995-04-01), pages 403-405, XP000516195 ISSN: 0018-8689

## Description

This invention relates to an apparatus for the surface treatment of sheet materials. To be specific, it relates to an apparatus for the surface treatment to be used, for example, in a process for the production of printed wiring boards for the purpose of imparting the surface treatment to the printed wiring boards being conveyed by spouting a processing liquid against the surface of the printed wiring boards.

Various sheet materials such as, for example, printed wiring boards, glass sheets for use in color filters, glass sheets for use in plasma displays (PDP), and sheet materials for use in electronic parts are manufactured by a procedure which comprises cutting relevant sheet materials in prescribed sizes, giving the cut sheet materials various chemical treatments, and subjecting the chemically treated cut sheet materials to numerous surface treatments including washing treatments.

For these surface treatments, the uniformity of a surface treatment performed on the outer surface of a given sheet material and the cost of the surface treatment constitute themselves the most important themes. Now, an example of the process for the production of printed wiring boards which represent the sheet materials mentioned above will be described below.

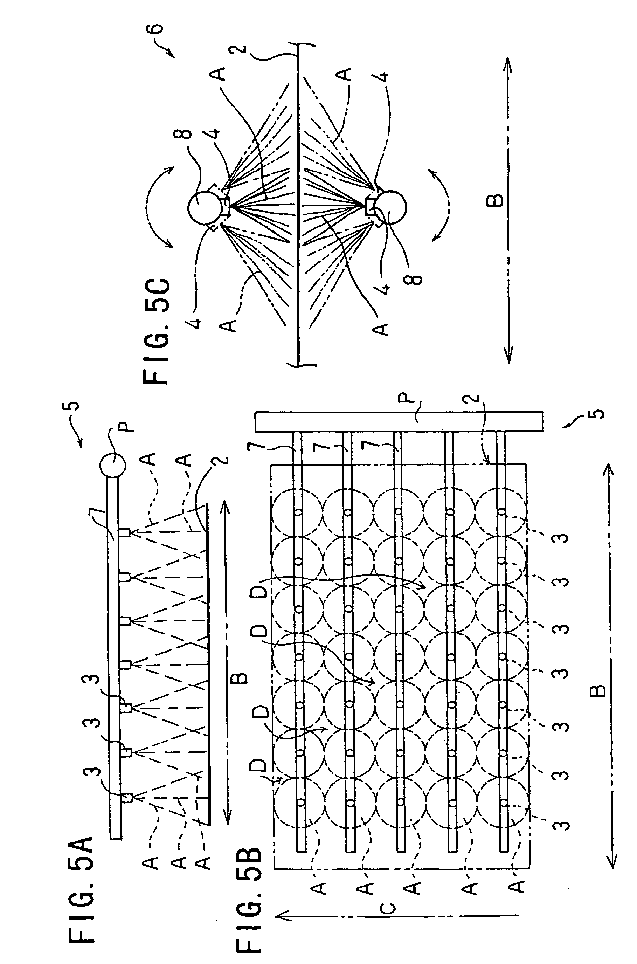

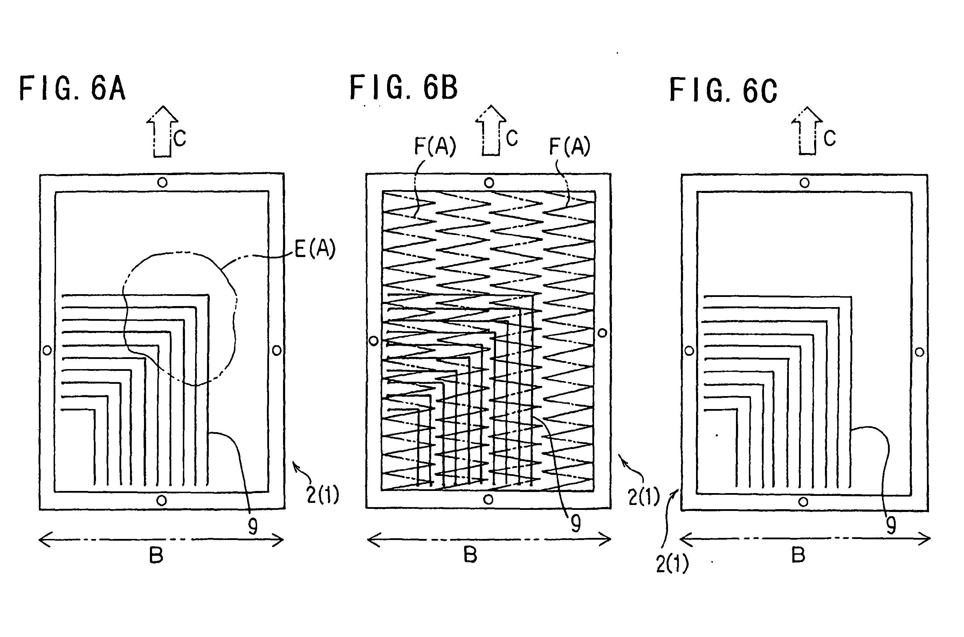

Fig. 5 represents a conventional example of the process of interest; Fig. 5A illustrates a front view of a first example, Fig. 5B a plan view, and Fig. 5C s front view of the essential part of a second example. Fig. 6 is an explanatory plan view of a printed wiring board; Fig. 6A illustrates an example of a liquid pool in the conventional example, Fig. 6B loci of spouts in the conventional example, and Fig. 6C a normal example.

A printed wiring board 1 is produced by continuously following numerous steps such as cutting a printed wiring board material 2 having an insulating substrate coated throughout with a copper foil forming through-holes in the cut printed wiring board material 2 and polishing and plating the through-holes applying drying or patching an etching resist to the perforated printed wiring board material 2 exposing the material 2 to light through a negative film containing a circuit pattern developing the circuit pattern on the material 2 etching the developed circuit pattern stripping the circuit part of the material 2 of the etching resist.

At such developing, etching, and stripping steps as are performed on the printed wiring board material 2, the printing wiring board material 2 is sprayed, while it is being conveyed therethrough, with processing liquids A such as developer, etchant, and stripping agent spouted through the spray nozzles 3 and 4 so as to be given chemical treatments for the purpose of developing, etching, and stripping actions. At these and other steps of the process of production, the printed wiring board material 2 is given relevant washing treatments which resort to the spouting of a rinsing liquid.

Such surface treatments as chemical treatments and washing treatments described above have been heretofore carried out as follows.

At such surface treating devices 5 and 6 as a developing device, an etching device, and a stripping device, the processing liquids A are spouted through a multiplicity of spray nozzles 3 and 4 disposed correspondingly against the printed wiring board materials 2 conveyed in a horizontal posture sequentially by a conveyor (not shown) to impart surface treatments to the printed wiring board sheet materials 2.

The processing liquids A forwarded through pipe lines P are branched and advanced under pressure to spray tubes 7 and 8 and spouted through a multiplicity os spray nozzles 3 and 4 disposed fast at fixed pitches in the parallelly arranged spray tubes 7 and 8.

In the surface treating device 5 illustrated as the first example in Fig. 5A and Fig. 5B, the spray nozzles 3 are disposed fast in the spray tubes disposed fast along the direction of width B as pointed directly downward (or directly upward) and are consequently allowed to spout processing liquids A at a right angle against the printed wiring board materials 2.

In contrast, in the surface treating device 6 illustrating as the second example in Fig. 5C, the spray tubes 8 are parallelly disposed along the direction of longitudinal conveyance C and, at the same time, adapted to produce a reciprocating motion (rotation) around the axes thereof continuously toward the direction of width B. The spray nozzles 4 disposed fast in such spray tubes 8, therefore, are allowed to produce oscillations reciprocations (rotations) in the direction of width B and consequently spout the processing liquids A against the printed wiring board materials 2 sequentially in the direction of left and the direction of right with the inclined angles of spouting varied with oscillations (rotations).

In the third example of surface treating device not shown in the drawing, the spray tubes 8 disposed as arranged along the direction of longitudinal conveyance C are adapted to produce a continuous reciprocating motion as pointed toward the direction of with B. In this example, the spray nozzles 4 also produce a continuous horizontal reciprocation as pointed toward the direction of width B and consequently spout the processing liquids A against the printed wiring board materials 2 sequentially in the direction of left and the direction of right with a right angle of spouting directly downward (or directly upward).

Incidentally, it has been pointed out that such conventional examples as described above entail the following problems.
a. First, in the surface treating device 5 of the first example illustrated in Fig. 5A and Fig. 5B, since the processing liquids A are spouted through the spray nozzles 3 which are fixed as pointed directly downward (or directly upward) as illustrated Fig. 5A, the occurrence of many blank areas D on the printed wiring board materials 2 which are not reached by the jets of processing liquids A spouted through the spray nozzles 3 has been pointed out.

The head oscillation type surface treating device 6 as the second example illustrated in Fig. 5 C and the horizontal reciprocation type surface treating device as the third example not illustrated in the drawing have been developed and put to use with a view to eliminating the numerous blank areas D which are formed in the first example mentioned above.
b. In the surface treating device 6 of the second example or the third example, however, it has been pointed out that the spouted processing liquids A are stagnated in the form of one or more bulging liquid pools in the central part of the outer surface of each of the printed wiring board materials 2 as illustrated in Fig. 6A.

Specifically, the processing liquids A spouted ought to flow toward the opposite directions of width B of the outer surfaces of the printed wiring board materials 2 and, after performing surface treatments to the outer surfaces, flow down the opposite lateral sides of the materials 2.

In contrast, in the surface treating device 6 of the second example or the third example, since the spray nozzles 4 oscillate or horizontally reciprocate, the jets of the processing liquids A spouted toward each other in the direction of width B are allowed to affect each other. Thus, the processing liquids A do not flow smoothly in the opposite directions of width B but produce random turbulences in all directions and tend to form one or more liquid pools E at the central part. Even in the case of the first example mentioned above, the occurrence of such turbulences and liquid pools E has been pointed out.
c. Further, it has been pointed out that in the second example or the third example, the processing liquids A are inevitably spouted in loci F resembling streaks against the outer face of the printed wiring board materials 2 as illustrated in Fig. 6B. That is, the surface treating device 6 of the second example or the third example suffers the processing liquids A to be spouted in loci F resembling laterally zigzagging streaks in consequence of the oscillations and the horizontal reciprocations produced by the spray nozzles 4 in the opposite directions of width B.

The occurrence of such loci F resembling streaks as described above can be appreciably repressed by controlling the speed of conveyance of the printed wiring board materials 2 by a conveyor. It has not been easy, however, to match the distances and durations of the oscillations and the horizontal reciprocations with the speed of conveyance by the conveyor. In the further light of the need to increase the speed of conveyance for the sake of expediting the treatment, it has been held difficult to effect perfect elimination of the loci F resembling streaks.

In the surface treating devices 5 and 6 of the first, second, and third examples of the conventional apparatus, the occurrence of such blank areas D, liquid pools E, and loci F resembling streaks as described above has been pointed out. Then, the problem that such adverse phenomena inevitably impair the uniformity of the surface treatment given to the printed wiring board materials 2 has been pointed out.

The processing liquids A are varied in density between the blank areas D of processing liquid A and other portions, between the liquid pools E of processing liquid A and other portions, or between the portions of loci F resembling streaks of processing liquid A and other portions and the processing effects produced on the outer surfaces of the printed wiring board materials 2 by the processing liquids A are deprived of uniformity as a whole.

Since such chemical treatments as developing treatment, etching treatment, and stripping treatment and a rinsing treatment as well, for example, are effected unevenly, they proceed fast or slow or excessively or insufficiently and produce uneven and dispersed results and entail the problem of impairing the uniformity of the width of circuits 9 to be eventually formed. This situation can hardly be tolerated by the printed wiring boards 1 whose circuits 9 are advancing toward densification, miniaturization, and exaltation of accuracy.

It has been pointed out that the conventional examples of this class, in the first place, encounter the problem of depriving the relevant treatments of uniformity as described above.

In the second place, regarding the surface treating devices 5 and 6 as the first, second, and third examples of the conventional apparatus, the problem that the printed wiring boards 1 obtained thereby suffer from poor yield and consequently inferior productivity and high cost of production as well because they include rejected products copiously owing to such lack of uniformity of treatment as mentioned above has been pointed out.

Further, as regards the surface treating device 6 as the second or third example mentioned above, the problem that for the purpose of enabling the spray tubes 8 and the spray nozzles 4 to produce an oscillation reciprocation or a horizontal reciprocation, all the spray tubes 8 require provision of an oscillation mechanism or a horizontal reciprocation mechanism and the apparatus entails a high cost of equipment has been pointed out. In the conventional example of this class, the problem in terms of cost has been pointed out in the second place as described above.

A discussion on different spray nozzle configurations can be found in "Spray Nozzle Configurations for Minimising Develop/Etch Rate and Uniformity", IBM Technical Disclosure Bulletin, IBM Corp. New York, US, vol. 38, no. 4, 1 April 1995 (1995-04-01), pages 403-405, XP000516195, ISSN: 0018-8689.

This invention has been perfected as a result of the inventor's diligent study initiated in view of such true state of prior art and pursued in search of a solution for the problems encountered by the conventional examples mentioned above. Specifically, it has for an object thereof the provision of a device for the surface treatment of a sheet material, which by having spray nozzles pointed toward the opposite directions of width and fixed at inclined angles of spouting, firstly eliminates blank areas, liquid pools, and loci resembling streaks and renders the treatment uniform wholly and secondly excels in cost of production and cost of equipment.
Fig. 1 is a front view to be used in describing the mode of embodying this invention with respect to a surface treating device for sheet materials according to this invention.
Fig. 2 is a plan view to be used in describing the mode of embodying the same invention.
Fig. 3 is a side view to be used in describing the mode of embodying the same invention.
Fig. 4 is used for describing the mode of embodying this invention; Fig 4A is a front view of the essential part, Fig. 4B is a front view of the other essential part, Fig. 4C is a front view of a spray nozzle, Fig. 4d is a side view of the essential part, and Fig. 4E is a plan view of the essential part.
Fig. 5 is used for describing the mode of embodying the conventional example of this class; Fig. 5A is a front view of the first example, Fig. 5B is a plan view thereof, and Fig. 5C is a front view of the essential part of the second example.
Fig. 6 is an explanatory diagram of a printed wiring board material; Fig. 6A illustrates an example of liquid pool in the conventional example of this class, Fig. 6B illustrates loci of jets in the conventional example of this class, and Fig. 6C illustrates a normal example.
Fig. 7 is a plan view to be used for describing an embodiment this invention, illustrating one example of the positional relation of individual spray nozzles.
Fig. 8 is a plan view to be used for describing another embodiment of this invention, illustrating one example of the positional relation of individual spray nozzles.

The present invention provides apparatus for successively imparting a surface treatment to discrete sheet materials, conveyed in a horizontal posture by a conveyor, by spouting a processing liquid (A) against said discrete sheet materials through a multiplicity of oppositely positioned spray nozzles, said spray nozzles being pointed toward the direction of the conveyor's width (B), relative to the direction of longitudinal conveyance (C) and, at the same time, fixed at an inclined angle (G) of spouting relative to the horizontal,
wherein said processing liquid (A) spouted through said spray nozzles impinges on said sheet materials at said angle (G) of spouting in the direction of width (B) and provides on the outer surface of said sheet materials a regular flow containing neither a pool nor turbulence in said processing liquid (A),
the apparatus being characterised by:
said conveyor being provided with two adjacent horizontal rows each of a multiplicity of conveying rollers for vertically nipping said sheet materials and conveying them horizontally, longitudinal intervals being formed between conveying rollers,
said spray nozzles being positioned opposite said longitudinal intervals, and
receiving rollers being positioned opposite the longitudinal intervals for infallibly supporting the sheet materials against the pressure of the jet of the processing liquid (A), and
regulating rollers for preventing said processing liquid (A), spouted through said spray nozzles against said sheet materials, from flowing on the outer surface of said sheet materials in said longitudinal direction of conveyance (C), said regulating rollers being disposed across the width as opposed to the outer surface of said sheet materials and, at the same time, formed as pairs of two members, one either side of each said longitudinal interval.

The present invention is constructed as described above and, therefore, is operated as follows. The device for the surface treatment is used, for example, in a process for the production of printed wiring boards by spouting processing liquids such as developer, etchant, peeling agent, and rinsing agent through the spray nozzles against sheet materials such as printed wiring board materials being conveyed in a horizontal posture as nipped between opposed rows of conveying rollers of one conveyor.

The spray nozzles are positioned opposite the intervals spaced in the longitudinal direction through the collection of conveying rollers as pointed toward the direction of left or the direction of right at every other of the longitudinal intervals. Those of the spray nozzles pointed toward the direction of left and those pointed to the direction of right throughout the entire length of the device are substantially equal in quantity. The spray nozzles which are disposed as fixed at obliquely inclined downward or upward angles of spouting are capable of varying and adjusting these angles of spouting and fixing them as so adjusted.

The processing liquids which have been spouted through the spray nozzles perform required treatments on the outer surface of the sheet materials as they flow toward the direction of left or the direction of right and thereafter flow down from the opposite lateral sides.

By further disposing pairs of regulating rollers and symmetrically positioning spray nozzles in the longitudinally adjacent intervals in the regulating rollers, it is made possible to prevent the processing liquids from flowing in the longitudinal direction and consequently ensure to a greater extent the flow of the processing liquids in the direction of left or the direction of right. The regulating rollers may utilize the conveying rollers concurrently or they may utilize stationary rollers exclusively.

Since the processing liquids are made to form their flows regularly as described above, they do not give rise to any blank area, turbulence, liquid pool, or loci resembling streaks on the sheet materials. When the spray nozzles, which are copiously disposed longitudinally and laterally are, by way of an additional contrivance, positioned with lateral deviation as viewed in the mutual relation, rather than symmetrically, the points of impingement of the processing liquids on the sheet materials do not suffer overlap.

The sheet materials, consequently, are enabled by the homogenized processing liquids to undergo such surface treatments as the treatment with a chemical and the treatment with a rinsing agent uniformly throughout the entire surface thereof and prevent the treatments from advancing with undue slowness or undue fastness, proceeding excessively or insufficiently, and yielding uneven and dispersed results.

### Best mode of embodying the invention

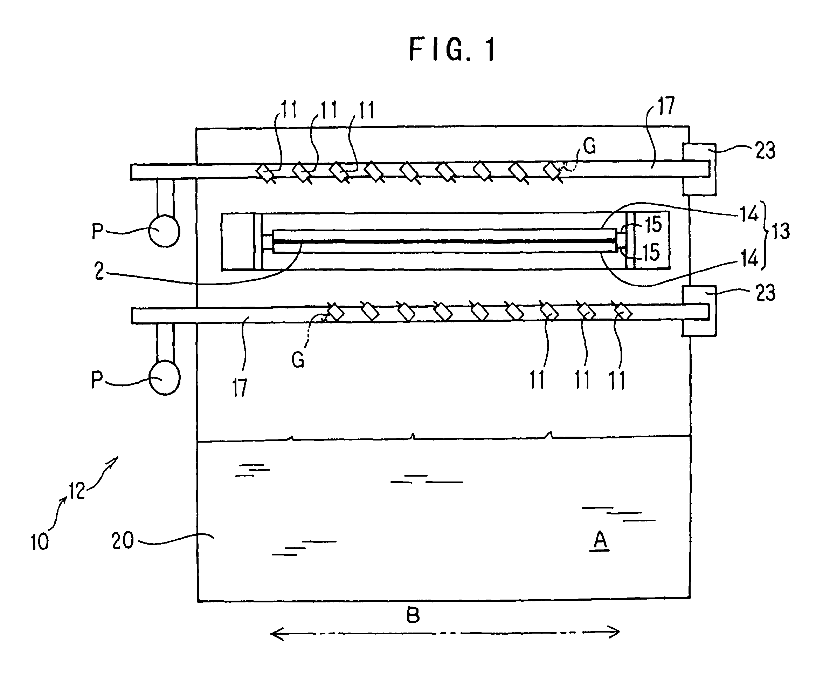

Now, the present invention will be described in detail below based on the modes of embodying this invention illustrated in the accompanying drawings. Fig. 1, Fig. 2, Fig. 3, Fig. 4, Fig. 7, and Fig. 8 are offered as aids in the description of the modes of embodying this invention.

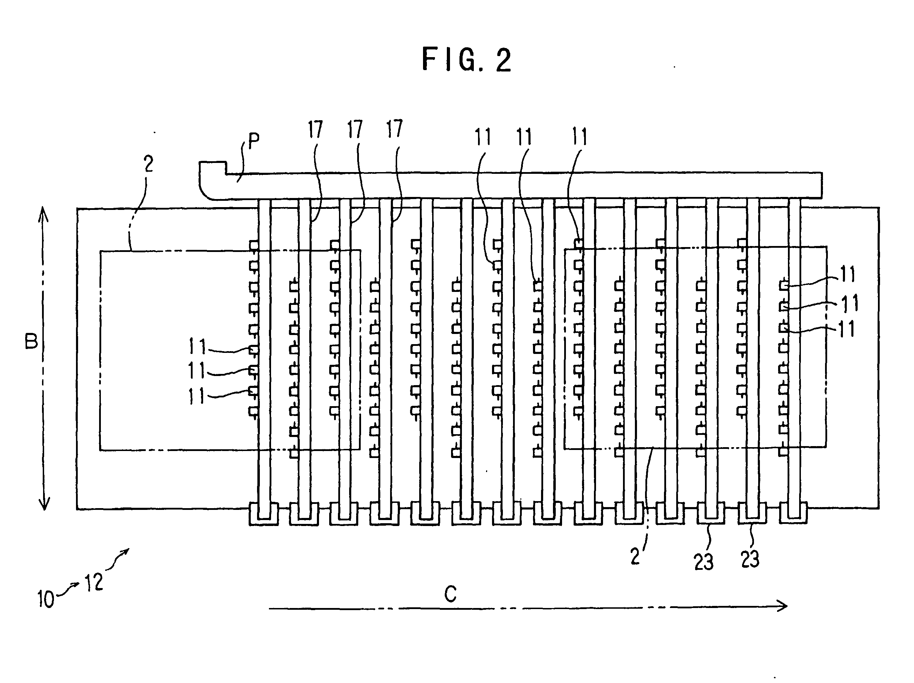

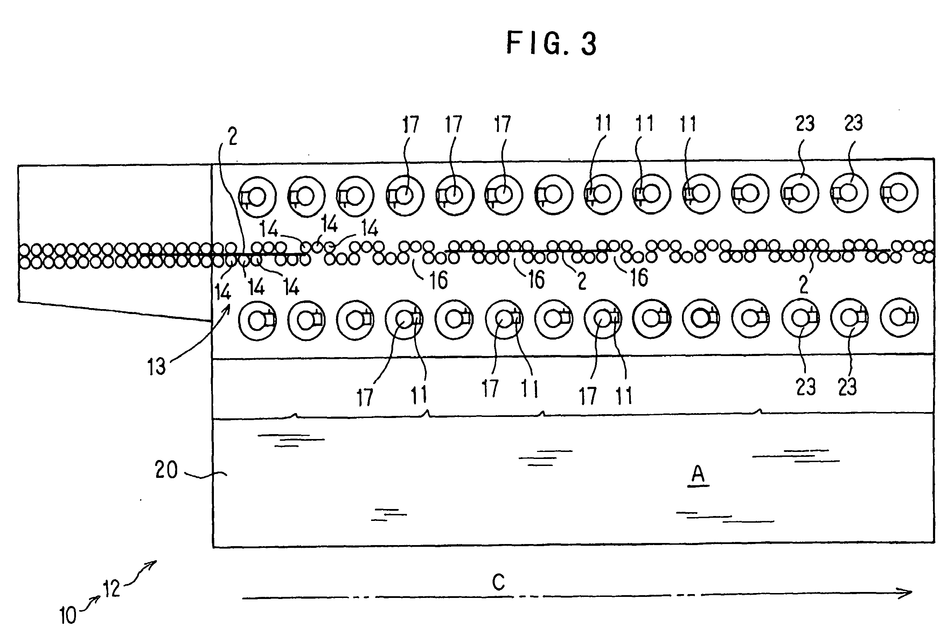

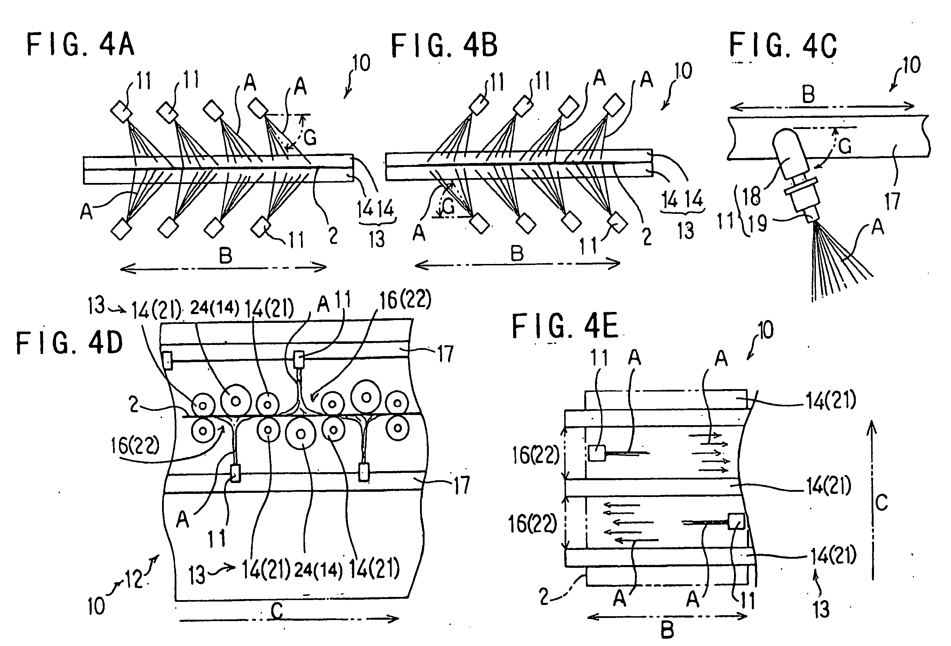

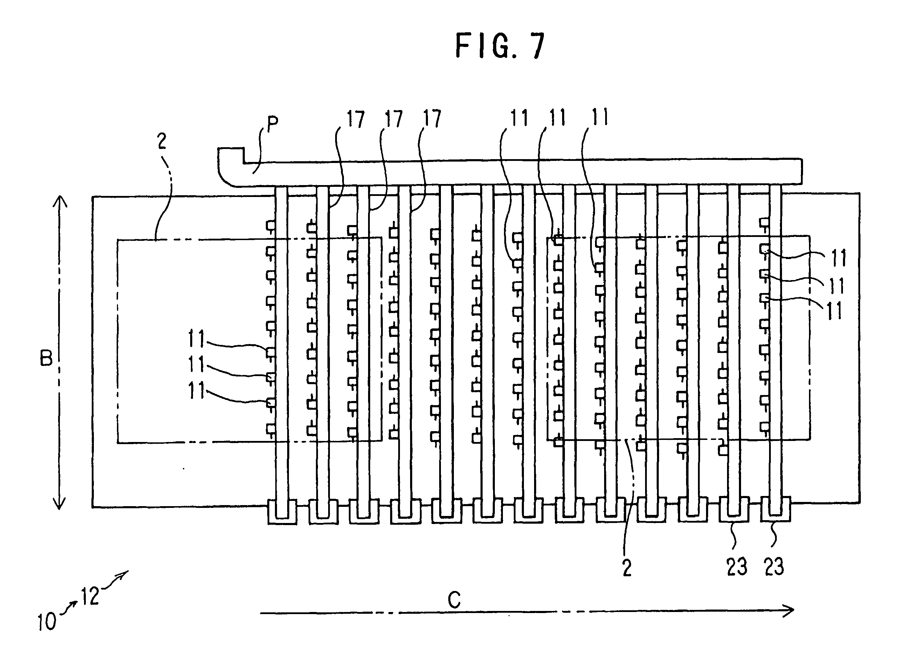

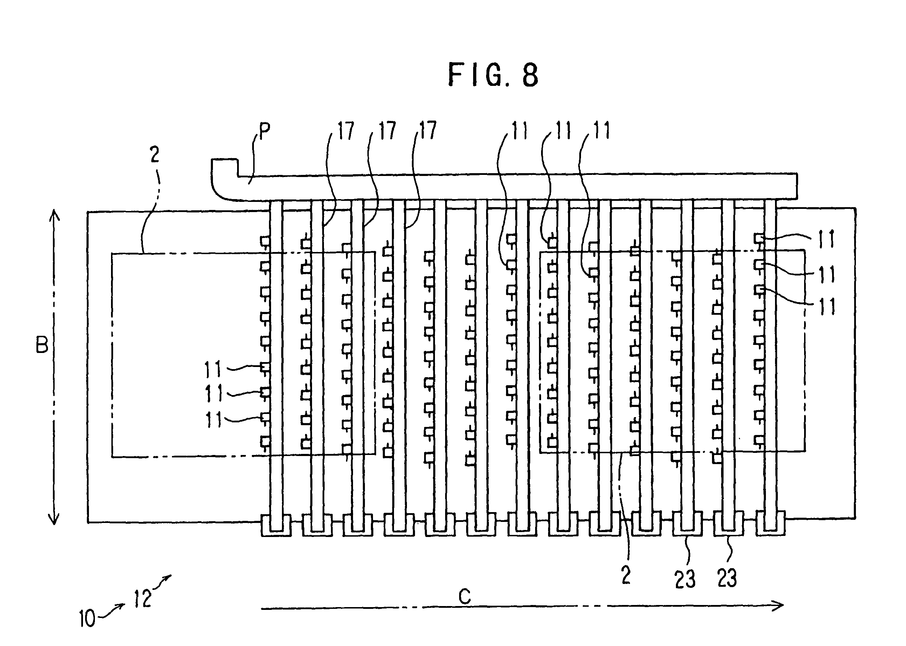

Specifically, Fig: 1 is a front view, Fig. 2 a plan view, and Fig. 3 a side view. Fig. 4A is a front view illustrating the essential part, Fig. 4B a front view illustrating the other essential part, Fig. 4C a front view of spray nozzles, Fig. 4D a side view illustrating the essential part, and Fig. 4E a plan view illustrating the essential part. Fig. 7 and Fig. 8 are plan views respectively illustrating one example of the positional relation of the disposed spray nozzles and another example thereof.

A device 10 for the surface treatment of this invention is used, for example, in a process for the production of printed wiring boards 1. For a start, the printed wiring board 1 will be described with reference to the plan view of Fig. 6C.

The printed wiring board 1 finds utility in various applications such as the substrate for a varying OA device, the substrate for a portable telephone, the substrate for a computer, the substrate for a calculating machine, and the substrate for other electronic device. The process for the production of this printed wiring board 1 is known in various types. As kinds of the printed wiring board 1, a single-sided substrate, a double-sided substrate, a multilayer substrate (including the version of the recent build-up technique), and a flexible substrate are conceivable, though not quite satisfactorily. As one additional link in the chain of these varieties, the CSP and PBGA which are associated with semiconductor chips and packages have recently debuted.

In recent years, the printed wiring boards 1 have been showing an increasingly more prominent trend toward miniaturization, further decrease in weight, growth in fineness, extreme decrease in film thickness, exaltation of flexibility, and addition to the quantity of component layers. Particularly, the circuits 9 formed on the outer face have been advancing toward densification, growth in fineness, and growth in accuracy.

The printed wiring board 1 of this construction, for example, is produced as follows. To be specific, a printed wiring board material 2 as a sheet material is subjected sequentially to such numerous steps as lamination, cutting, perforation for forming through-holes, plating, application of etching resist and drying of applied layer or mounting of etching resist, exposure to light, development, etching, and separation of etching resist from parts of circuit 9 to produce the printed wiring board 1.

Now, this method for the production of the printed wiring board 1 will be described more specifically below. First, a laminate is formed by joining copper foils one each as by hot press to the opposite sides of an insulating substrate made of polyimide or other resin or glass cloth and the laminate is cleaned and polished. Then, the laminate is subjected to soft etching for coarsening the surfaces of the copper foils. At the same time, the printed wiring board 2, i.e. a laminate having copper foils fastened to the opposite surfaces thereof, which has resulted from the pretreating steps mentioned above is cut into segments intended as work blanks.

Then, the work blanks are subjected to a perforating work which is intended to form through-holes, cleaned, and polished on both sides thereof, and then subjected to a panel plating work. The inner walls of the through-holes are plated to establish continuity between the circuit 9 to be formed on the obverse side and the circuit 9 to be formed on the reverse side in consequence of the panel plating mentioned above.

(Incidentally, there are times when a laminate having a copper foil fastened to one side {obverse side or reverse side} of an insulating substrate is used instead as the printed wiring board material 2. In this case, the operations such as application of a photosensitive resist, exposure to light, development, etching, peeling, etc. which will be described herein below are performed on only the one side of the laminate. Naturally, this modification of the present invention is applicable to the one-sided substrate grade printed wiring board material 2 and to the printed wiring board 1 as well. This principle is similarly applicable herein below.)

The through-holes of an extremely small diameter are formed in such a large quantity as totals some hundreds to some thousands in each printed wiring board sheet material 2 (printed wiring board 1).

Thereafter, the printed wiring board sheet material 2 is again subjected to such works as cleaning, polishing, cleaning, and drying and then to a coating treatment which comprises applying an etching resist, i.e. a photosensitive resist of an alkali-resistant or acid-resistant protective film and drying the applied layer.

Then, the outer surfaces, i.e. obverse and reverse sides, destined to form circuits 9 thereon are exposed to light through circuit photographs which are negative films of circuits 9. The circuit 9 portions of the photosensitive resist which have been exposed to light and hardened are left intact and the remaining unnecessary portions thereof are dissolved and removed by exposure to the jet of the processing liquid A which is a developer.

After the printed wiring board sheet material 2 has been subsequently cleaned and dried as described above, the copper foil on the circuit 9 portions coated and protected by the hardened photosensitive resist are left intact and the copper foil on the unnecessary portions from which the photosensitive resist has been dissolved and removed are dissolved and removed in the form of etching by exposure to the jet of the processing liquid A which is an etchant.

Then, the photosensitive resist on the hardened circuit 9 portions which have survived the cleaning and drying work mentioned above is dissolved and removed by exposure to the jet of the processing liquid A, i.e. a peeling liquid and the remaining hardened circuit 9 portions are cleaned and dried. As a result, the remaining copper foil gives rise to prescribed circuits 9 and affords the printed wiring board 1.

The printed wiring board 1 produced in consequence of an operation of sequentially performing such steps as mentioned above is then subjected to a step of aftertreatment which comprises forming a protective coat with a photosensitive resist for the produced circuit 9 through steps approximating closely to the steps mentioned above except for necessary modifications.

The printed wiring board 1 measures, for example, approximately 550 mm × 550 mm, 500 mm × 500 mm, or 500 mm x 300 mm respectively in length and width. The wall thickness of the printed wiring board 1 is approximately 0.06 mm, for example, in the portion of the insulating substrate and in the approximate range of 0.18 µm to 55 µm, for example, in the circuit 9 portions made of copper foil.

Even the printed wiring board 1 is in the form of a multi-layer substrate having a multiplicity, for example, four component layers superposed has come to follow the trend of acquiring an extremely small thickness such that the total wall thickness thereof is in the approximate range of from 1.0 mm to 0.8 mm, or even to 0.4 mm. Also the width of the circuit 9 is tending to decrease from 70 µm to 50 µm and further from 30 µm to 20 µm. The need for forming circuits 9 with a width of 20 µm and separating them with a space of about 30µm, for example, has been emerging. The peripheral edge portions, about 10 mm in width, of the outer surfaces on which the circuits 9 have been formed constitute themselves selvage widths, i.e. exposed cores.

The printed wiring board 1 is produced as described above.

Now, the surface treating deice 10 of this invention will be explained below with reference to Fig. 1, Fig. 2, Fig. 3, and Fig. 4.

This surface treating device 10 performs a surface treatment on the outer surfaces of discrete sheet materials such as, for example, printed wiring board materials 2 being conveyed one after another by spouting processing liquids A against the outer surfaces through a multiplicity of spray nozzles 11 disposed opposite the sheet materials. The surface treating device 10 illustrated in the drawing is used in a process for the production of the printed wiring board 1 mentioned above. The sheet materials are printed wiring board materials 2 and the processing liquids A are developer, etchant, peeling agent, and rinsing liquid. The surface treatment comprises development, etching, peeling, and rinsing.

Now, the case of using the surface treating device 10 in the process for the production of such printed wiring boards 1 will be specifically described below.

At the developing, etching, and peeling steps mentioned above in the process for the production of the printed wiring boards 1, the printed wiring board materials 2 are conveyed one after another through the interiors of one or more treating chambers 12 of the surface treating device 10 which are called the developing unit, etching unit, and peeling unit. By the processing liquids A, i.e. chemical liquids of developer, etchant, and peeling agent, being spouted against the printed wiring board materials being conveyed as described above through the spray nozzles 11, the surface treatments which are chemical treatments for developing, etching, and peeling actions are carried out.

At such developing, etching, and peeling steps and at other steps of the process of production, a rinsing treatment is performed as an accessorial operation as described above. To be specific, as the printed wiring board sheet materials 2 are conveyed one after another through the interior of the treating chamber 12 for rinsing, the processing liquid A, i.e. a rinsing liquid, is spouted through the spray nozzles 11 against the printed wiring board sheet materials 2 to effect the surface treatment for rinsing.

To begin with, a conveyor 13 of this surface treating device 10 will be described below. The printed wiring board sheet materials 2 in the interior of the treating chamber 12, as illustrated in Fig. 2 and Fig- 3, are conveyed laterally in a horizontal posture by the conveyor 13.

The conveyor 13 is provided with two rows each of a multiplicity of conveying rollers 14 adapted to nip the printed wiring board materials vertically and conveying them horizontally. Inside the treating chamber 12, a multiplicity of conveyor shafts 15 are horizontally disposed parallelly to the direction of width B in the longitudinal direction C of conveyance. On the conveyor shafts 15, the conveying rollers 14 are respectively disposed coaxially.

These conveying rollers 14 comprise long cylindrical straight rolls and nipping rollers and have a length slightly greater than the width of the printed wiring board materials 2. The conveyor shafts 15 and the conveying rollers 14 are disposed in two vertically opposed rows so as to nip the printed wiring board sheet materials 2 and convey them.

These conveyor shafts 15 and conveying rollers 14 may be in any of various conceivable forms. In the example illustrated in Fig. 3, the conveying rollers 14 having one equal diameter are disposed as vertically opposed alternately in the direction of conveyance C so as to envelop the printed wiring board sheet materials 2 in a nipped state.

That is, the conveying rollers 14 illustrated in the drawing are arranged closely both in the upper and the lower row and, at the same time, are vertically paired alternately (at every fourth roller on the upper and the lower side) to form longitudinal intervals 16 of a size equivalent to each of the pairs. Then, the longitudinal intervals 16 on the upper side and the longitudinal intervals 16 on the lower side are not set oppositely but staggered in the direction of conveyance C.

Of course, the conveyor shafts 15 and the conveying rollers 14 do not need to limit their shapes to those which are illustrated in the drawings but may assume any of various other conceivable shapes. In the example illustrated in Fig. 4D, for instance, the conveying rollers 14 which are positioned opposite the longitudinal intervals 16 on the upper side or the lower side have a larger diameter than the other conveying rollers 14. Thus, they function as receiving rollers 24 for infallibly supporting the printed wiring board sheet materials 2 against the pressure of the jet of the processing liquid A.

The positions of the conveyor shafts 15 and the conveying rollers 14, the combination of varying diameters of the conveying rollers 14, etc. possibly admit numerous variations. What is essential is the fact that those which serve the purpose of nipping printed wiring board sheet materials 2 vertically and forwarding them vertically and those which are positioned opposite the upper or the lower longitudinal intervals 16 on the lower or the upper side and are used for supporting the printed wiring board sheet materials 2 are duly provided.

The example, as illustrated, has longitudinal intervals 16 formed on both the upper side and the lower side. These longitudinal intervals 16 are formed on either of the sides mentioned above when the printed wiring board sheet materials 2 are intended for one-sided substrates.

The conveyor 13 of the surface treating device 10 is constructed as described above.

Now, the spray nozzles 11 of this surface treating device 10 will be described below.

For a start, the pipe P connected to a pump (not shown) and operated for forwarding the processing liquid A under pressure is ramified and connected to a multiplicity of spray pipes 17 as illustrated in Fig. 1, Fig. 2, and Fig. 3.

These spray pipers 17, in the example illustrated in drawings, are laid parallel to the opposite directions of width B as spaced at a fixed pitch in the direction of longitudinal conveyance C in an approximate total of ten odd pieces. These spray pipes 17 are oppositely disposed on the upper side and the lower side across the printed wiring board sheet materials 2 being conveyed and the conveying rollers 14 of the conveyor 13.

Then, on each of such spray pipes 17, a multiplicity of spray nozzles 11 such as, for example, an approximate total of ten odd pieces, are disposed as spaced at a fixed pitch in the direction of width B. That is, in the total inner area of the treating chamber 12, a multiplicity of spray nozzles 11 are disposed as spaced longitudinally and laterally at respectively fixed pitches. These spray nozzles 11 and spray pipes 17 are disposed on both the upper side and the lower side when the printed wiring board sheet materials 2 are for use in double-sided substrates as in the illustrated example or they are disposed on only one side when the said materials 2 are for use in single-sided substrates.

As in the example illustrated in Fig. 4D conversely to the example illustrated in Fig. 1, Fig. 2, and Fig. 3, the spray pipes 17 may be copiously disposed as laid parallel not to the opposite directions of width B but to the direction of longitudinal conveyance C as spaced at a fixed pitch in the opposite directions of width B. The spray nozzles 11 are copiously disposed as separated by a fixed pitch from the spray pipes 17 disposed longitudinally as described above.

Incidentally, the diagram of Fig. 2 omits illustrating the conveyor 13 and the conveying rollers 14.

The spray nozzles 11, as illustrated in Fig. 2, are pointed toward the opposite directions of width B which perpendicularly intersect the direction of conveyance C. The spray nozzles 11 are positioned respectively opposite the longitudinal intervals 16 formed in the conveying rollers 14 of the conveyor 13 as illustrated in Fig. 3 and, at the same time, pointed toward the direction of left (refer to Fig. 4B) or the direction of right (refer to Fig. 4A) with respect to each of the longitudinal intervals 16 as illustrated in Fig. 2.

Then, in the example illustrated in Fig. 2, both the spray nozzles 11 disposed on the upper side and the spray nozzles 11 disposed on the lower sides respectively have the rows of spray nozzles 11 pointed toward the direction of left and the rows of spray nozzles 11 pointed toward the direction of right in the direction of width B alternately pointed toward the direction of conveyance C.

Then, the spray nozzles 11 pointed toward the direction of left and the spray nozzles 11 pointed toward the direction of right have substantially (or even perfectly) equal totals in the entire apparatus. After all, the surface treating device 10 as a whole is required to have those of the spray nozzles 11 pointed toward the direction of left and those pointed toward the direction of right in substantially equal quantities.

Notwithstanding the example illustrated in the drawing, the spray nozzles 11 pointed toward the direction of left and the spray nozzles 11 pointed toward the direction of right may be disposed as sequentially alternated at every third or fourth row. The spray nozzles 11 may be otherwise disposed as alternated in the upstream part and the downstream part of the interior of the treating chamber 12. When the surface treating device 10 is formed of two treating chambers 12, the spray nozzles 11 may be disposed as alternated between the treating chamber 12 on the upstream side and the treating chamber 12 on the downstream side.

Incidentally in the illustrated example, a multiplicity of spray nozzles 11 are disposed on one spray pipe 17. Notwithstanding this illustrated example, a small number of spray nozzles 11 or a sole spray nozzle 11 may be disposed on one spray pipe 17. Even in this case, the device as a whole has the spray nozzles pointed toward the direction of left and the spray nozzles pointed toward the direction of right in substantially equal totals.

In the example illustrated in Fig. 1, Fig. 2, and Fig. 3, the spray nozzles 11 are projected toward the direction of longitudinal conveyance C relative to the spray pipes 17 which are disposed as pointed toward the opposite directions of width B. In contrast, in the example illustrated in Fig. 4D, the spray nozzles 11 are projected toward the opposite directions of width B relative to the spray pipes 17 which are disposed as pointed toward the direction of longitudinal conveyance C.

The spray nozzles 11 are pointed toward the opposite directions of width B which perpendicularly intersect the direction of conveyance C as described above and, at the same time, are disposed as fixed at an inclined angle G of spouting from the horizon as illustrated in Fig. 1, Fig. 4A, 4B, and 4C. The spray nozzles 11, without discrimination between those pointed toward the direction of eft and those pointed toward the direction of right, are fixed on the spray pipes 17 at fixed angles G, i.e. 30 degree, 45 degree, 60 degrees, etc. from the horizon.

Specifically, the spray nozzles 11 disposed on the upper side of the printed wiring board materials 2 are set at an angle of spouting G inclined downwardly from the horizon. The spray nozzles 11 disposed on the lower side of the printed wiring board sheet materials 2 are set at an angle of spouting G inclined upwardly from the horizon.

In the illustrated example, the angles of spouting U of the individual spray nozzles 11 taken mutually on the upper side are commonly identically set and the angles of spouting U of the individual spray nozzles 11 taken mutually on the lower side are commonly identically set and further the two sets of angles of spouting G on the upper side and the lower side are likewise set commonly identically.

Incidentally, these spray nozzles 11 allow their obliquely inclined angles of spouting U to be altered and adjusted and further fixed at suitably altered and adjusted angles.

Such a spray nozzle 11, as illustrated in Fig. 4C, is composed of a main body part 18 and a spouting orifice 19. The main body part 18 is set rotatably to the spray pipe 17 and, at the same time, fixed at a suitable angle of spouting U which is optionally varied. By this variation of the angle of spouting 0, the angle U at which the processing liquid A is spouted by the spouting orifice 19 can be freely varied, adjusted, and fixed. It is further made possible by the variation and adjustment of this angle of spouting 0 to set properly the pressure of spouting of the processing liquid A against the printed wiring board sheet materials 2 and the speed of the flow of the processing liquid A to b eventually formed.

The spray nozzles 11 of the surface treating device 10 are constructed as described above.

Now, the processing liquid A which is spouted through the spray nozzles 11 in the surface treating device 10 will be described below.

The jets of the processing liquid A emanating from the spray nozzles 11, as illustrated in Figs. 4A, 4B, 4C, and 4D, are caused to impinge at angles of spouting F obliquely inclined toward the direction of left or the direction of right on the printed wiring board sheet materials 2 and then form regular flows entailing neither liquid poor nor turbulence as pointed toward the direction of left or the direction of right on the outer surfaces of the printed wiring board sheet materials 2 as illustrated in Fig. 4E.

Specifically, the jets of the processing liquid A emanating through the spouting orifices 19 of the spray nozzles 11 are spread and diffused and eventually caused, in a state entraining pressure, to impinge on the outer surfaces of the printed wiring board sheet materials 2. Then the jets of the processing liquid A spouted through the spray nozzles 11 as pointed toward the direction of left are allowed to flow regularly on the outer surfaces of the printed wiring board sheet materials 2 as pointed toward the direction of left. The jets of the processing liquid A spouted through the spray nozzles 11 as pointed toward the direction of right are allowed to flow regularly on the outer surfaces of the printed wiring board sheet materials 2 as pointed toward the direction of right. The outer surfaces of the printed wiring board sheet materials 2, consequently, undergo such prescribed surface treatments as developing, etching, peeling, and rinsing.

Subsequently, the processing liquid A is allowed to flow down the opposite lateral sides of the outer surfaces of the printed wiring board sheet materials 2 and flow out of the device.

In the lower part of the treating chamber 12, a liquid tank 20 is formed. The processing liquid A which has flowed down the printed wiring board sheet materials 2 and flowed out of the device eventually collects into the liquid tank 20 to be recovered and stored. The processing liquid A stored in the liquid tank 20 is optionally given a reinforcing treatment and then forwarded under pressure by a pump to the pipe P and put to cyclic use.
The illustrated example is further provided with a multiplicity of regulating rollers 21 as illustrated in Figs. 4D and 4E.

These regulating rollers 21 fulfill the function of preventing the processing liquid A spouted through the spray nozzles 11 against the printed wiring board sheet materials 2 from flowing toward the direction of longitudinal conveyance C on the outer surfaces of the printed wiring board sheet materials 2.

The regulating rollers 21 are disposed as confronted by the outer surfaces of the printed wiring board sheet materials 2 and meanwhile laid along the opposite directions of width B and are used as paired off as interposed between the adjacent longitudinal intervals 22. The spray nozzles 11 are positioned opposite the longitudinal intervals 22 formed by the regulating rollers 21.

In the illustrated example, the conveying rollers 14 are used concurrently as the regulating rollers 21.

To be specific, the regulating rollers 21 have the peculiar function of inhibiting the processing liquid A from flowing toward the direction of conveyance C as described above. They may be optionally disposed independently as exclusively stationary rollers between the conveying rollers 14 of the conveyor 13. That is, the regulating rollers 21 may be disposed between the longitudinal intervals of the conveying rollers 14 as exclusive stationary rollers independently of the conveying rollers 14. Then, these regulating rollers 21 are disposed as paired off inclusively of the longitudinal intervals 22 commensurate with the width of the flow of the processing liquid A. The spray nozzles 11 are oppositely positioned on the center lines between the longitudinal intervals 22. In contrast, the illustrated example is devised to utilize the conveying rollers 14 of the conveyor 13 concurrently as such regulating rollers 21. Specifically, the longitudinal intervals 16 of the conveying rollers 14 are set at such longitudinal intervals 22 as commensurate with the width of the flow of the processing liquid A and, at the same time, the spray nozzles 11 are oppositely positioned on the center line between these longitudinal intervals 16. The conveying rollers 14, consequently, are enabled to function concurrently as regulating rollers 21 directly as paired off. The reference numeral 23 in Fig. 1 and Fig. 2 denotes a holder part for the spray pipes 17.

The processing liquid A which has been spouted behaves as follows.

This invention is constructed as described above. It, therefore, operates as follows.

This surface treating device 10 is used, for example, in the process for the production of printed wiring boards 1. In this surface treating device 10, the processing liquid A such as developer, etchant, peeling agent, or rinsing agent is spouted through the oppositely disposed spray nozzles 11 against the printed wiring board sheet materials 2 which are being conveyed in a horizontal posture toward the direction of longitudinal conveyance C as vertically nipped by the conveying rollers 14 of the conveyor 13 (refer to Fig. 1, Fig. 2, and Fig. 3).

The spray nozzles 11 are oppositely positioned between the longitudinal intervals 16 formed in the conveying rollers 14 and, at the same time, are pointed toward the direction of left or the direction of right of the direction of width B in each of the longitudinal intervals 16. The spray nozzles 11 pointed toward the direction of left and the spray nozzles 11 pointed toward the direction of right have substantially equal totals in the entire device.

Then, the spray nozzles 11 are disposed as fixed at angles of spouting 0 obliquely inclined downward or upward from the horizon. Incidentally, these angles of spouting U can be varied and set and then fixed at the properly varied and adjusted angles (refer to Fig. 4C).

The jets of the processing liquid A emanating from the spray nozzles 11, therefore, are caused to impinge on the printed wiring board sheet materials 2 at the angles of spouting 0 obliquely inclined toward the direction of left or the direction of right. Then, the processing liquid A flows regularly on the outer surfaces of the printed wiring board sheet materials 2 as pointed toward the direction of left or the direction of right and flows down the opposite lateral sides and flows out of the device (refer to Figs. 4A, 4B, 4C, 4D, and 4E).

Incidentally, when the regulating rollers 21 are disposed as confronted by the printed wiring board sheet materials 2 and laid along the opposite directions of width B and the spray nozzles 11 are oppositely positioned between the longitudinal intervals 22 of the regulating rollers 21 which are used as paid off, they bring about the following effect. That is, the regulating rollers 21 are enabled to prevent the processing liquid A from flowing toward the direction of longitudinal conveyance C (refer to Figs. 4D and 4E).

Thus, the flow of the processing liquid A as pointed toward the direction of left or the direction of right can be realized infallibly and regularly. While these regulating rollers 21 may be diverted from the conveying rollers 14 of the conveyor 13, they may be disposed between the conveying rollers 14 through the medium of exclusively stationary rollers.

By the processing liquid A flowing on the outer surfaces of the printed wiring board sheet materials 2 toward the direction of left or the direction of right as described above, the outer surfaces of the printed wiring board sheet materials 2 are subjected to such surface treatments as developing, etching, peeling, or rinsing. The surface treating device 10, consequently, produces the first and the second operation as follows.

Firstly, the flow of the processing liquid A is regularly formed on the outer surfaces of the printed wiring board sheet materials 2 as described above. The processing liquid A, therefore, avoids generating many blank areas D incapable of being reached by the processing liquid A (refer to Fig. 5B), advancing turbulently in all directions, giving rise to one or more liquid pools of the processing liquid A in the central part (refer to Fig. 6A), or describing loci F resembling streaks (refer to Fig. 6B). (The flow of the processing liquid A does not need to be matched with the speed of conveyance.)

The outer surfaces of the printed wiring board sheet materials 2, consequently, are furnished uniformly throughout with such surface treatments as with chemicals and rinsing agent owing to the processing liquid A which is uniformized as described above.

On the printed wiring board sheet materials 2, therefore, such surface treatments as developing treatment, etching treatment, peeling treatment, chemical treatment, and rinsing treatment are infallibly and uniformly carried out without entailing difference in treating speed, uneven progress of treatment, occurrence of marks of uneven dispersed treatment.

Secondly, the use of this surface treating device 10 permits easy manufacture of printed wiring board materials 1 supporting circuits 9 of a prescribed width (refer to Fig. 6C). In the process for the production of printed wiring boards 1, therefore, the ratio of occurrence of rejectable products is prominently decreased and, at the same time, the amount of the processing liquid A to be used is saved.

Moreover, in this surface treating device 10, the spray nozzles 11 and the spray pipes 17 are invariably fixed. In other words, the surface treating device 10 does not need to be furnished with a mechanism for imparting oscillations to the spray nozzles 11 or the spray pipes 17 (refer to Fig. 5C) or a mechanism for imparting a horizontal reciprocation thereto.

Thus, the surface treating device 10 is characterized by a construction for causing the spray nozzles 11 to be obliquely inclined as pointed toward the direction of width B and fixed in the inclined state. It enjoys simplicity of construction.

The operation of the surface treating device 10 of this invention has been described.

The spray nozzles 11, in the first place, are copiously disposed as separated by prescribed pitches longitudinally and laterally. A visual observation of the spray nozzles 11 which are adjacently disposed longitudinally reveals that they are mutually in such a relation as to be oppositely positioned in the example illustrated in Fig. 2. That is, these longitudinally adjacent spray nozzles are severally positioned in parallel linear loci parallel to the direction of longitudinal conveyance C.

This invention, however, does not need to limit the spray nozzles 11 to the positional relationship just described. The individual spray nozzles 11 as viewed in the direction of longitudinal conveyance C may be so positioned that the longitudinally adjacent intervals thereof may deviate in the opposite directions of width B from the parallel linear loci as in the following examples a, b, c, and d.

These examples a, b, c, and d have in common the fact that the spray nozzles 11 are disposed (on the spray pipes 17) as separated by a prescribed pitch in the direction of longitudinal conveyance C and, at the same time, disposed (on the spray pipes 17) as separated by a prescribed pitch in the opposite directions of width B which also applies to the example illustrated in Fig. 2.
a. First, the example illustrated in Fig. 7 is conceivable. Specifically, in this example a illustrated in Fig. 7, the individual spray nozzles 11 disposed on spray pipes 17 are gradually and slightly deviated sequentially in either of the opposite directions of width B. In this example, the spray nozzles 11 in the most upstream side row and the spray nozzles 11 in the most downstream side row, for example, eventually deviate halfway in the entire length thereof in the direction of width B by a space approximating closely to one pitch and, therefore, are allowed to be positioned substantially oppositely.
b. Then, the example illustrated in Fig. 8 is conceivable. The longitudinal spray nozzles 11 in this example are deviated fairly largely, though gradually, in either of the opposite directions of width B as compared with those of the example of a described above. In this example, the spray nozzles 11 in the most upstream side row and the spray nozzles 11 in the most downstream side row eventually deviate in a plurality of repetitions halfway in the entire length thereof by a space approximating closely to one pitch and, therefore, are allowed to be positioned substantially oppositely.
c. In this example, similarly to the example as illustrated in Fig. 7, all the spray nozzles 11 are not deviated. The spray nozzles 11 of the groups which are disposed on a total of seven alternately disposed spray pipes 17 and pointed toward the direction of left are gradually deviated sequentially and slightly in either of the opposite directions of width B. Eventually, therefore, the spray nozzles 11 in the most upstream side row and the spray nozzles 11 in the most downstream side row deviate halfway in the entire length thereof by a space approximating closely to one pitch and, therefore, are allowed to be positioned substantially oppositely. The spray nozzles 11 of the groups which are disposed on a total of seven alternately disposed spray pipes 17 and pointed toward the direction of right are positioned as similarly deviated.
d. In this example, the longitudinal spray nozzles 11 are deviated largely, though gradually, toward either of the opposite directions of width B as compared with those in the example c described above. After all, in this example, as regards the spray nozzles 11 of the groups which are pointed toward the direction of left and as regards the spray nozzles 11 of the groups which are pointed toward the direction of right as well, the spray nozzles 11 in the most upstream side row and the spray nozzles 11 in the most downstream side row eventually deviate in a plurality of repetitions halfway in the entire length thereof by a space approximating closely to one pitch and, therefore, are allowed to be positioned substantially oppositely.

When the longitudinal spray nozzles 11 are positioned as mutually deviated laterally as in the examples of a, b, c, and d described above, they bring the following advantages as compared with the example which has the spray nozzles 11 disposed so as to be oppositely positioned as illustrated in Fig. 2.

Specifically, the jets of the processing liquid A spouted through the spray nozzles 11 and pointed against the printed wiring board sheet materials 2 produce a decreased number of overlapping points. Even from this point of view, the surface treatments mentioned above are uniformly promoted on the printed wiring board sheet materials 2.

That is, the points at which the jets of the processing liquid A spouted through the spray nozzles 11 are caused to impinge on the printed wiring board sheet materials have less possibility of falling on one and the same linear locus lying along the direction of conveyance C. At the points of impingement, the jets have the highest pressure, the processing liquid A has the highest density, and the impact of treatment has the greatest strength. From the viewpoint of the fact that these points are not suffered to overlap but are dispersed, the surface treatments bring the advantage of uniformizing the processing liquid A and the surface treatments as well.

As the second place, the illustrated example described thus far has the surface treating device 10 applied to the process for the production of printed wiring boards 1 which are one example of sheet materials. This invention does not need to be limited to this application.

It is applicable, for example, to glass sheets for use in color filters, glass sheets for use in plasma display devices (PDP), and other sheet materials. In short, it is widely applicable to various processes which perform a variety of surface treatments by spouting a processing liquid A through the spray nozzles 11 against various kinds of sheet material being conveyed.

The surface treating device for sheet materials according to this invention derives the following effects from fixing the spray nozzles at angles of spouting obliquely inclined toward the opposite directions of width as described above.

Firstly, such defects as bland area, liquid pool, and loci resembling streaks are eliminated and the treatments are uniformized throughout.

By this surface treating device for sheet materials, the processing liquid spouted through the spray nozzles flow regularly on the outer surfaces of the sheet materials toward the direction of left or the direction of right and then flows down the opposite sides and flow out of the device.

Since the processing liquid forms the flow as described above, it is infallibly freed from such defects as giving rise to blank areas incapable of being reached by the processing liquid between interposed spaces, suffering the processing liquid to flow turbulently in all directions and collect into a plurality of liquid pools in the central part, and describing loci resembling streaks which are inherently involved in the conventional examples of this class described above. The outer surfaces of the sheet materials, therefore, are given a uniform surface treatment throughout with the processing liquid which has been uniformized as described above.

When the surface treating device is used, for example, in the process for producing the printed wiring boards as one example of the sheet materials, it uniformly performs the chemical treatments such as developing, etching, and peeling treatments and rinsing treatments and infallibly avoids the occurrence of such defects as variation in speed of treatment, excessive or insufficient advance of treatment, and occurrence of signs of unevenness and dispersion which have been involved by the conventional examples of this class. As a result, the circuits formed on the outer surfaces are enabled to acquire a uniform width. This effect is particularly significant for printed wiring boards which are tending toward using circuits of higher density, fineness, and accuracy.

Secondly, the surface treatment device also excels in terms of the cost of production and the cost of equipment.

Specifically, since this surface treating device for sheet materials uniformizes the relevant treatments as described above, the sheet materials such as printed wiring boards which are produced by the process using the device are at an advantage in decreasing the number of rejectable products, exalting the yield, and saving the amount of the processing liquid to be used as compared with the conventional examples of this class. Thus, the surface treating device excels in productivity and cost of production.

Further, the spray pipes and the spray nozzles are invariably of the fixed types and do not need to be furnished with a mechanism for imparting an oscillating motion or a mechanism for producing a horizontal reciprocation unlike the conventional examples of this class. Thus, it enjoys simplicity of construction and excels in cost of equipment. To be specific, it allows about 20% of saving of the cost of production.

### Industrial Applicability

The surface treating device of this invention finds extensive utility in various applications for imparting surface treatments to discrete sheet materials such as, for example, glass sheets for use in printed wiring boards, glass sheets for use in colour filters, glass sheets for use in plasma displays (PDP), and sheet materials for use in electronic parts.

## Claims

1. Apparatus (10) for successively imparting a surface treatment to discrete sheet materials (2), conveyed in a horizontal posture by a conveyor (13), by spouting a processing liquid (A) against said discrete sheet materials (2) through a multiplicity of oppositely positioned spray nozzles (11), said spray nozzles (11) being pointed toward the direction of the conveyor's width (B), relative to the direction of longitudinal conveyance (C) and, at the same time, fixed at an inclined angle (G) of spouting relative to the horizontal,
wherein said processing liquid (A) spouted through said spray nozzles (11) impinges on said sheet materials (2) at said angle (G) of spouting in the direction of width (B) and provides on the outer surface of said sheet materials (2) a regular flow containing neither a pool nor turbulence in said processing liquid (A),
the apparatus being **characterised by**:
said conveyor (13) being provided with two adjacent horizontal rows each of a multiplicity of conveying rollers (14) for vertically nipping said sheet materials (2) and conveying them horizontally , longitudinal intervals (16) being formed between conveying rollers (14),
said spray nozzles (11) being positioned opposite said longitudinal intervals (16), and
receiving rollers (24) being positioned opposite the longitudinal intervals (16) for infallibly supporting the sheet materials (2) against the pressure of the jet of the processing liquid (A), and
regulating rollers (21) for preventing said processing liquid (A), spouted through said spray nozzles (11) against said sheet materials (2), from flowing on the outer surface of said sheet materials (2) in said longitudinal direction of conveyance (C), said regulating rollers (21) being disposed across the width as opposed to the outer surface of said sheet materials (2) and, at the same time, formed as pairs of two members, one either side of each said longitudinal interval (16).

2. Apparatus (10) for the surface treatment of sheet materials (2) according to claim 1, wherein the spray nozzles point in the direction of width (B) toward the left or the right in alternate longitudinal intervals (16).

3. Apparatus (10) for the surface treatment of sheet materials (2) according to claim 1 or claim 2, wherein the number of spray nozzles (11) pointing toward the direction of left and the number of spray nozzles (11) pointing toward the direction of right throughout the entire length of the apparatus are substantially equal in quantity.

4. Apparatus (10) for the surface treatment of sheet materials according to any of the preceding claims, wherein said spray nozzles (11) allow said angle (G) of spouting inclined from the horizon to be altered and adjusted and then to be fixed at the altered and adjusted angle.

5. Apparatus (10) for the surface treatment of sheet materials (2) according to claim 1, wherein the longitudinal intervals (16) formed in said rows of conveying rollers (14) on the upper side of said sheet materials, and the longitudinal intervals (16) formed in said rows of conveying rollers (14) on the lower side of said sheet materials, are not opposite one another but are staggered in the direction of conveyance (C).

6. Apparatus (10) for the surface treatment of sheet materials (2) according to any of the preceding claims, wherein said spray nozzles (11) are copiously arranged longitudinally and laterally and the intervals between the longitudinally adjacent spray nozzles (11) are positioned not in an opposite relation but in a laterally deviated relation.

7. Apparatus (10) for the surface treatment of sheet materials (2) according to any of the preceding claims, wherein said spray nozzles (11) are copiously arranged longitudinally and laterally and, with respect to those spray nozzles (11) pointed toward the direction of left of width (B), the intervals between the adjacent spray nozzles (11) are positioned not in an opposed relation but in a laterally deviated relation and, with respect to those spray nozzles (11) pointed toward the direction of right of width (B), the intervals between the longitudinally adjacent spray nozzles (11) are positioned not in an opposed relation but in a laterally deviated relation.

8. Apparatus (10) for the surface treatment of sheet materials (2) according to any of the preceding claims, wherein said apparatus (10) is used for the process of production of a printed wiring board, said sheet materials (2) comprise printed wiring boards, and said processing liquid (A) is a developer, an etchant, a stripping liquid, or a rinsing liquid.

9. Apparatus (10) for the surface treatment of sheet materials (2) according to any of the preceding claims, wherein receiving rollers (24) are conveying rollers (14).

10. Apparatus (10) for the surface treatment of sheet materials (2) according to any of the preceding claims, wherein regulating rollers (21) are conveying rollers (14).

## Patentansprüche

1. Vorrichtung (10), um diskrete Lagenmaterialien (2), die in einer horizontalen Haltung durch eine Fördereinrichtung (13) befördert werden, nacheinander mit einer Oberflächenbehandlung zu beaufschlagen, indem über mehrere gegenüberliegend positionierte Sprühdüsen (11) eine Verarbeitungsflüssigkeit (A) gegen die diskreten Lagenmaterialien (2) ausgestoßen wird, wobei die Sprühdüsen (11) in Bezug auf die Richtung (C) der Längsförderung in Richtung der Breite (B) der Fördereinrichtung weisen und gleichzeitig unter einem geneigten Ausstoßwinkel (G) in Bezug auf die Horizontale festgesetzt sind,
wobei die durch die Sprühdüsen (11) ausgestoßene Verarbeitungsflüssigkeit (A) unter dem Ausstoßwinkel (G) in Richtung der Breite (B) auf die Lagenmaterialien (2) auftrifft und auf der Außenoberfläche der Lagenmaterialien (2) einen regelmäßigen Fluss liefert, der weder eine Lache noch eine Turbulenz in der Verarbeitungsflüssigkeit (A) enthält,
wobei die Vorrichtung **dadurch gekennzeichnet ist, dass**
die Fördereinrichtung (13) mit zwei angrenzenden horizontalen Reihen, jeweils mit mehreren Förderwalzen (14), versehen ist, um die Lagenmaterialien (2) vertikal einzuklemmen und sie horizontal zu befördern, wobei zwischen den Förderwalzen (14) Längsabstände (16) gebildet sind,
die Sprühdüsen (11) den Längsabständen (16) gegenüberliegend positioniert sind,
Aufnahmewalzen (24) gegenüber den Längsabständen (16) positioniert sind, um die Lagenmaterialien (2) fehlerfrei gegen den Druck des Strahls der Verarbeitungsflüssigkeit (A) zu unterstützen, und
Regulierungswalzen (21) verhindern, dass die durch die Sprühdüsen (11) gegen die Lagenmaterialien (2) ausgestoßene Verarbeitungsflüssigkeit (A) in der Längsrichtung der Förderung (C) auf der Außenoberfläche der Lagenmaterialien (2) fließt, wobei die Regulierungswalzen (21) entgegengesetzt zu der Außenoberfläche der Lagenmaterialien (2) über die Breite angeordnet sind und gleichzeitig als Paare zweier Glieder, eines auf jeder Seite jedes Längsabstands (16), gebildet sind.

2. Vorrichtung (10) für die Oberflächenbehandlung von Lagenmaterialien (2) nach Anspruch 1, bei der die Sprühdüsen in abwechselnden Längsabständen (16) in Richtung der Breite (B) nach links oder nach rechts weisen.

3. Vorrichtung (10) für die Oberflächenbehandlung von Lagenmaterialien (2) nach Anspruch 1 oder Anspruch 2, bei der die Mengen der Anzahl der Sprühdüsen (11), die in Linksrichtung weisen, und der Anzahl der Sprühdüsen (11), die in Rechtsrichtung weisen, über die gesamte Länge der Vorrichtung im Wesentlichen gleich sind.

4. Vorrichtung (10) für die Oberflächenbehandlung von Lagenmaterialien nach einem der vorangehenden Ansprüche, bei der die Sprühdüsen (11) zulassen, dass der Ausstoßwinkel (G) gegen den Horizont geneigt ist, um geändert und eingestellt und daraufhin unter dem geänderten und eingestellten Winkel festgesetzt zu werden.

5. Vorrichtung (10) für die Oberflächenbehandlung von Lagenmaterialien (2) nach Anspruch 1, bei der die in den Reihen von Förderwalzen (14) auf der Oberseite der Lagenmaterialien gebildeten Längsabstände (16) und die in den Reihen der Förderwalzen (14) auf der Unterseite der Lagenmaterialien gebildeten Längsabstände (16) in der Förderrichtung (C) einander nicht gegenüberliegen, sondern versetzt sind.

6. Vorrichtung (10) für die Oberflächenbehandlung von Lagenmaterialien (2) nach einem der vorangehenden Ansprüche, bei der die Sprühdüsen (11) längs und quer zahlreich angeordnet sind und die Abstände zwischen den in Längsrichtung angrenzenden Sprühdüsen (11) nicht in einer entgegengesetzten Beziehung, sondern in einer seitlich abweichenden Beziehung positioniert sind.

7. Vorrichtung (10) für die Oberflächenbehandlung von Lagenmaterialien (2) nach einem der vorangehenden Ansprüche, bei der die Sprühdüsen (11) längs und quer zahlreich angeordnet sind und in Bezug auf jene Sprühdüsen (11), die in Linksrichtung der Breite (B) weisen, die Abstände zwischen den angrenzenden Sprühdüsen (11) nicht in einer entgegengesetzten Beziehung, sondern in einer seitlich abweichenden Beziehung positioniert sind und in Bezug auf jene Sprühdüsen (11), die in Rechtsrichtung der Breite (B) weisen, die Abstände zwischen den längs angrenzenden Sprühdüsen (11) nicht in einer entgegengesetzten Beziehung, sondern in einer seitlich abweichenden Beziehung positioniert sind.

8. Vorrichtung (10) für die Oberflächenbehandlung von Lagenmaterialien (2) nach einem der vorangehenden Ansprüche, bei der die Vorrichtung (10) für den Prozess der Herstellung einer Leiterplatte verwendet wird, wobei die Lagenmaterialien (2) Leiterplatten umfassen und die Verarbeitungsflüssigkeit (A) ein Entwickler, ein Ätzmittel, eine Ablöseflüssigkeit oder eine Spülflüssigkeit ist.

9. Vorrichtung (10) für die Oberflächenbehandlung von Lagenmaterialien (2) nach einem der vorangehenden Ansprüche, bei der die Aufnahmewalzen (24) Förderwalzen (14) sind.

10. Vorrichtung (10) für die Oberflächenbehandlung von Lagenmaterialien (2) nach einem der vorangehenden Ansprüche, bei der die Regulierungswalzen (21) Förderwalzen (14) sind.

## Revendications

1. Appareil (10) pour faire subir successivement un traitement de surface à des matériaux en feuilles séparés (2) transportés dans une position horizontale par un transporteur (13), en projetant un liquide de traitement (A) sur lesdits matériaux en feuilles séparés (2) par une multiplicité de buses de pulvérisation (11) opposées, lesdites buses de pulvérisation (11) étant dirigées dans le sens de la largeur (B) du transporteur, par rapport à la direction de transport longitudinal (C) et, en même temps, fixées suivant un angle de projection (G) incliné par rapport à l'horizontale,
dans lequel ledit liquide de traitement (A) projeté par lesdites buses de pulvérisation (11) frappe lesdits matériaux en feuilles (2) suivant ledit angle de projection (G) dans la direction de la largeur (B) et assure sur la surface externe desdits matériaux en feuilles (2) un flux régulier sans accumulation ni turbulence dans le liquide de traitement (A),
l'appareil étant **caractérisé en ce que**
ledit transporteur (13) est pourvu de deux rangées horizontales adjacentes, chacune d'une multiplicité de rouleaux de transport (14) pour pincer verticalement lesdits matériaux en feuilles (2) et les transporter horizontalement, des intervalles longitudinaux (16) étant formés entre des rouleaux de transport (14),
lesdites buses de pulvérisation (11) étant disposées à l'opposé desdits intervalles longitudinaux (16), et
des rouleaux de réception (24) étant disposés à l'opposé des intervalles longitudinaux (16) pour supporter de manière infaillible les matériaux en feuilles (2) à l'encontre de la pression du jet du liquide de traitement (A), et
des rouleaux de régulation (21) pour empêcher ledit liquide de traitement (A), projeté par lesdites buses de pulvérisation (11) sur lesdits matériaux en feuilles (2) de s'écouler sur la surface externe desdits matériaux en feuilles (2) dans ladite direction longitudinale de transport (C), lesdits rouleaux de régulation (21) étant disposés en travers de la largeur, par rapport à la surface externe desdits matériaux en feuilles (2) et, en même temps, formés comme des paires de deux éléments, l'un de chaque côté dudit intervalle longitudinal (16).

2. Appareil (10) pour le traitement de surface de matériaux en feuilles (2) selon la revendication 1, dans lequel les buses de pulvérisation sont dirigées dans la direction de la largeur (B), vers la gauche ou la droite dans des intervalles longitudinaux (16) alternés.

3. Appareil (10) pour le traitement de surface de matériaux en feuilles (2) selon la revendication 1 ou la revendication 2, dans lequel le nombre de buses de pulvérisation (11) dirigées vers la gauche et le nombre de buses de pulvérisation (11) dirigées vers la droite sur toute la longueur de l'appareil sont sensiblement égaux.

4. Appareil (10) pour le traitement de surface de matériaux en feuilles selon l'une quelconque des revendications précédentes, dans lequel lesdites buses de pulvérisation (11) permettent de modifier et d'ajuster ledit angle (G) de projection incliné sur l'horizontale, et ensuite de fixer l'angle modifié et ajusté.

5. Appareil (10) pour le traitement de surface de matériaux en feuilles (2) selon la revendication 1, dans lequel les intervalles longitudinaux (16) formés dans lesdites rangées de rouleaux de transport (14) du côté supérieur desdits matériaux en feuilles, et les intervalles longitudinaux (16) formés dans lesdites rangées de rouleaux de transport (14) du côté inférieur desdits matériaux en feuilles ne sont pas opposés les uns aux autres, mais sont disposés en quinconce dans la direction de transport (C).

6. Appareil (10) pour le traitement de surface de matériaux en feuilles (2) selon l'une quelconque des revendications précédentes, dans lequel lesdites buses de pulvérisation (11) sont disposées copieusement dans le sens longitudinal et dans le sens latéral, et les intervalles entre des buses de pulvérisation (11) longitudinalement adjacentes sont disposés, non de manière opposée, mais de manière déviée latéralement.

7. Appareil (10) pour le traitement de surface de matériaux en feuilles (2) selon l'une quelconque des revendications précédentes, dans lequel lesdites buses de pulvérisation (11) sont disposées copieusement dans le sens longitudinal et dans le sens latéral et, par rapport aux buses de pulvérisation (11) dirigées vers la gauche de la largeur (B), les intervalles entre les buses de pulvérisation (11) adjacentes sont disposés non de manière opposée, mais de manière déviée latéralement et, par rapport aux buses de pulvérisation (11) dirigées vers la droite de la largeur (B), les intervalles entre les buses de pulvérisation (11) longitudinalement adjacentes sont disposés non à l'opposé, mais de manière déviée latéralement.

8. Appareil (10) pour le traitement de surface de matériaux en feuilles (2) selon l'une quelconque des revendications précédentes, dans lequel ledit appareil (10) est utilisé dans le processus de production d'une plaquette de circuit imprimé, lesdits matériaux en feuilles (2) comprennent des plaquettes de circuit imprimé, et ledit liquide de traitement (A) est un révélateur, un mordant, un liquide de décapage ou un liquide rinçage.

9. Appareil (10) pour le traitement de surface de matériaux en feuilles (2) selon l'une quelconque des revendications précédentes, dans lequel des rouleaux de réception (24) sont des rouleaux de transport (14).

10. Appareil (10) pour le traitement de surface de matériaux en feuilles (2) selon l'une quelconque des revendications précédentes, dans lequel des rouleaux de régulation (21) sont des rouleaux de transport (14).
